Europäisches Patentamt

European Patent Office

Office européen des brevets

(19)

(11) Publication number: **0 232 510 B1**

## EUROPEAN PATENT SPECIFICATION

(12)

(45) Date of publication of patent specification: **25.03.92**　(51) Int. Cl.⁵: **H01L 29/06,** H01L 29/08

(21) Application number: **86117144.5**

(22) Date of filing: **09.12.86**

(54) **Semiconductor device having a plane junction with autopassivating termination.**

(30) Priority: **11.12.85 IT 662885**

(43) Date of publication of application:
**19.08.87 Bulletin 87/34**

(45) Publication of the grant of the patent:
**25.03.92 Bulletin 92/13**

(84) Designated Contracting States:
**DE FR GB NL**

(56) References cited:
**FR-A- 2 173 729**
**FR-A- 2 557 367**
**US-A- 4 215 358**
**US-A- 4 374 389**

(73) Proprietor: **SGS MICROELETTRONICA S.p.A.**
**Stradale Primosole 50**
**I-95121 Catania(IT)**

(72) Inventor: **Gandolfi, Luciano**
**Via Parini, 26**
**I-20094 Corsico (Mi)(IT)**
Inventor: **Musumeci, Salvatore, Dr.**
**Via Cascino, 146/B**
**I-95018 Riposto (CT)(IT)**

(74) Representative: **Klunker . Schmitt-Nilson .**
**Hirsch**
**Winzererstrasse 106**
**W-8000 München 40(DE)**

## Description

The present invention refers to an electronic semiconductor device of the type defined in the precharacterizing part of claim 1.

The invention is used for junction diodes, bipolar transistors, power transistors, Darlington transistor pairs, integrated circuits and similar semiconductor devices in which at least one plane junction is provided.

Devices of the above-mentioned tpye, so called "mesa" devices, comprise a PN junction terminated by means of a recess or cavity. Termination of this type is used for obtaining junctions having increased inverse breakdown voltages.

One drawback of the prior art devices results from the necessity to passivate the surface of the cavity or groove using a considerably thick layer of dielectric material in order to ensure stable electrical characteristics that are stable in terms of time. The passivation process which is, for example, realized by means of glass, is difficult and the possible further processing of discarded devices is expensive. Moreover, the materials used for the passivation step contain contaminations (e.g. glass contains mobile ions: $Na^+$, $K^+$, etc.), which are difficult to control and the undesired presence of which deteriorates the reproducibility of the fabricating process, thereby making it impossible to obtain constant physical and electrical characteristics of the completed devices. The reliability of the devices manufactured in the manner described above is poor, since the initial characteristics thereof are subject to variations, caused by migration of said contaminations.

The problem underlying the present invention is to provide a device of the above-mentioned type with plane junctions having increased inverse breakdown voltages without using dielectric materials for the termination of the junctions.

This problem is solved by the present invention defined in claim I. Preferred features of the invention are defined in the subclaims.

Preferred embodiments of the invention will now be discribed with reference to the attached drawings in which

Fig. I is a sectional view, not to scale, of a portion of a silicon chip comprising a NPN-type "mesa" power transistor having its plane collector-base junction passivated with glass, in accordance with the prior art,

Fig. 2 is a sectional view, not to scale, of a NPN-type power transistor according to the present invention,

Fig. 3 is a sectional view, not to scale, of a transistor similar to that shown in Fig. 2, according to a modified embodiment of the invention, and

Fig. 4 is a sectional view, not to scale, of a NPN-type power transistor according to a further embodiment of the present invention.

Referring now to Fig. I, there is shown, not according to scale, a sectional view of a part of a chip comprising an NPN-type power transistor implemented according to the prior art with a "mesa" recess.

The transistor is formed on a substrate I of monocrystalline silicon of $N^{++}$-type conductivity, wherein the impurity is in the order of $2.5 \times 10^{19}$ atoms/cm³. On the substrate I there is grown an epitaxial layer 2 of $N^-$-type conductivity with an impurity in the order of $I \times 10^{14}$ atoms/cm³. The substrate I and the epitaxial layer 2 constitute the collector region of the transistor. The collector electrode is represented by a metallic layer I0.

On the epitaxial layer 2 of the collector there is grown an epitaxial layer 3 of $P^-$-type conductivity having an impurity concentration in the order of $2 \times 10^{14}$ atoms/cm³, which constitutes the base region of the transistor. A diffusion region 4 of $P^+$-type conductivity having an impurity concentration at the surface in the order of $I \times 10^{18}$ atoms/cm³ is formed within the epitaxial layer 3 and constitutes a localized enhancement of the base region of the transistor for locally reducing the electrical field. A metallic element 9, which is in ohmic contact with said region 4 constitutes the base electrode of the transistor.

Within the enhanced base region 4, there is provided a diffused region 5 of $N^{++}$-type conductivity having an impurity concentration in the order of $I \times 10^{20}$ atoms/cm³. Diffused region 5 constitutes the emitter region of the transistor. A metallic element 8 having ohmic contact with region 5 constitutes the emitter electrodes of the transistor.

The channel stopper of the transistor is formed by a region 6 of $N^{++}$-type conductivity, realized by impurity diffusion of the same type and concentration as that of emitter region 5.

As will be used hereinbelow, the expression diffused region is applied to a region obtained by diffusing a doping material from a vapour phase, a liquid phase, a predeposition, ion implantation or according to any other wellknown technique.

The structure of Fig. I is covered by a silicon dioxide layer I3 which extends over the entire surface 7 of the epitaxial layer 3, with the exception of some apertures necessary for the contacts. Moreover, the structure comprises a groove or cavity II which surrounds the entire active portion of the device, i.e. the NPN power transistor. On the walls and on the bottom of the cavity II there is deposited insulating material I2, for example glass, which serves to passivate the plane junction 3-2 between base and collector.

Finally, in Fig. I there are depicted the equipotential lines for a predetermined inverse voltage of the collector-base junction of the transistor.

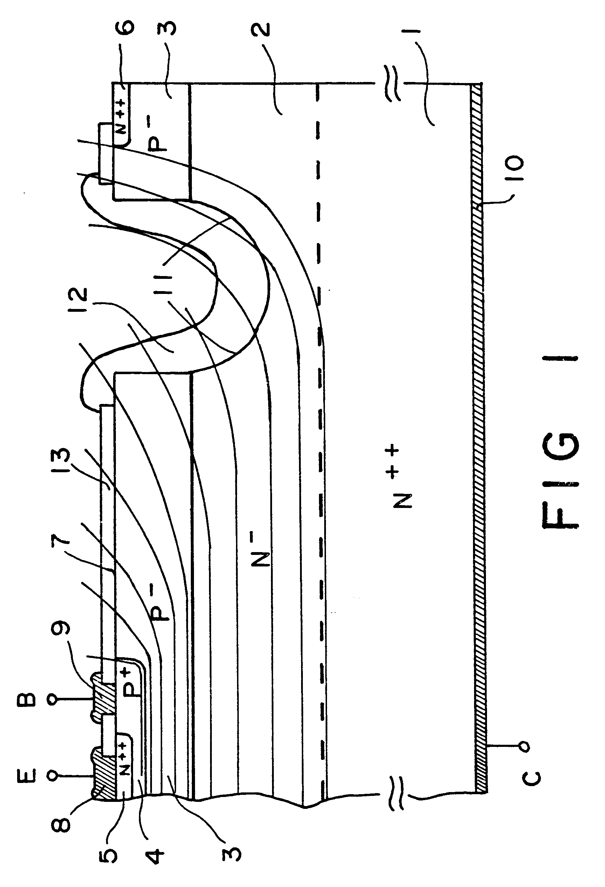

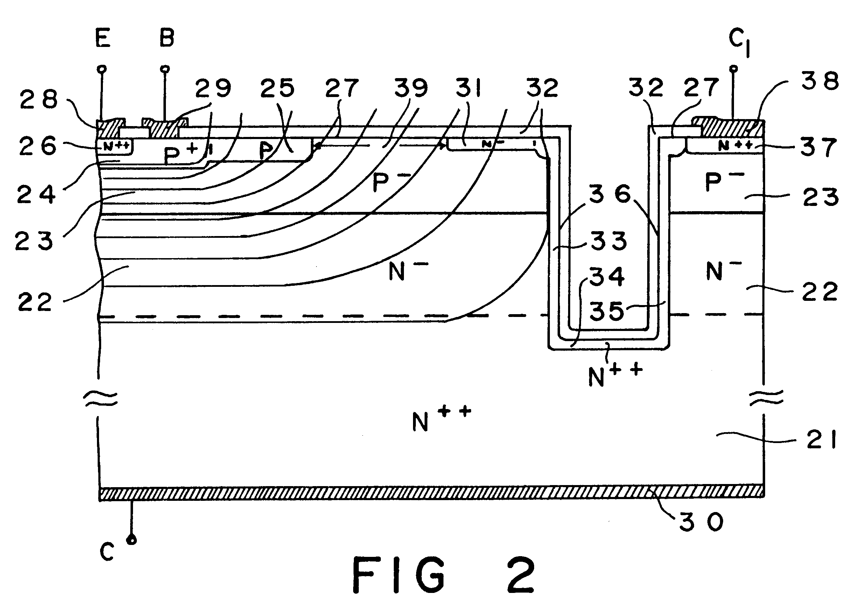

Referring now to Fig. 2, there is shown a sectional view (not to scale) of a portion of a silicon chip comprising a NPN power transistor according to the present invention.

The transistor is formed on a substrate 2l of monocrystalline silicon of high $N^{++}$-type conductivity, doped with antimony to a concentration of $2 \times l0^{19}$ atoms/cm$^3$. On the substrate 2l, there is grown on the entire area of the chip, an epitaxial layer 22 of $N^-$-type conductivity, doped with phosphorous to a concentration of $l \times l0^{14}$ atoms/cm$^3$, i.e. a concentration which is substantially lower than that of the substrate 2l. The concentration and the thickness of the epitaxial layer 22 are chosen in view of the breakdown voltage desired for the collector-base junction of the transistor of which the layers 2l and 22 together constitute the collector region, while layer 30 constitutes primary collector electrode C.

On the epitaxial layer 2l of the collector there is grown, on the entire area of the chip, an epitaxial layer 23 of the opposite conductivity type $P^-$ by doping with boron to a concentration of $l \times l0^{14}$ atoms/cm$^3$. Boron impurities with a dose of $5 \times l0^{14}$ atoms/cm$^2$ are implanted within a predetermined horizontal region into a zone 24 of this epitaxial layer. The implantation of boron is repeated with a dose of $3 \times l0^{12}$ atoms/cm$^2$ within an adjacent additional zone 25 having a width of 90 micrometers. For simplifying the manufacturing process the second implantation may be carried out for both zones 24 and 25. Thereby, within zone 24 boron is implanted into zone 24 with a dose of $5.03 \times l0^{14}$, while boron is implanted into zone 25 with a dose of $3 \times l0^{12}$ atoms/cm$^2$. Following this is a thermal treatment step at a high temperature for diffusing the implanted impurities. Thereby, a diffused base region is formed having a graded or stepped concentration profile with a higher concentration within zone 24.

The epitaxial layer 23 and regions 24, 25 together constitute the base region of the transistor according to the present invention. The base electrode is formed by a metallic element 29 which is in ohmic contact with region 24.

Then, a shallow region 3l is formed which delimits the active area of the transistor on the surface. The width of this region may be about 90 $\mu$m, while the depth thereof may be about 5 $\mu$m. The region may be obtained by implantation of phosphorous with a dose of $2 \times l0^{11}$ atoms/cm$^2$, followed by a diffusion step.

Then, a groove or cavity 36 is formed by cutting or by means of chemical attack, following the external border of region 3l. The depth of groove 36 is such that the groove penetrates into substrate 2l.

After formation of the groove or cavity, an impurity of $N^{++}$-type conductivity is diffused into the walls 33 and 35 and on the bottom 34 of the groove. The impurity is constituted by phosphorous having an increased surface concentration of about $l \times l0^{20}$ atoms/cm$^3$ which diffuses and penetrates into the material for a thickness of about 5 $\mu$m.

In accordance with the above-described process the collector of the transistor of the present invention is constituted by regions 2l, 22, 33, 34, 35, 3l, 37. The collector has a primary electrode C, consisting of a metallic layer 30 which covers the back surface of the chip. Moreover, an auxiliary electrode $C_1$ is formed on the surface 27 and is constituted of a metallic element 38. The last mentioned auxiliary electrode is not used in case the transistor is designed for dissipation of high power. However, the auxiliary electrode is useful for other applications of the device of the present invention.

The metallic element 38 constituting the auxiliary electrode $C_1$ is in ohmic contact with a diffused region 37, having high $N^{++}$-type conductivity, region 37 being doped with phosporous to at a surface concentration of $l0^{19}$ atoms/cm$^3$. The diffused region is formed in advance and does not create any PN junction with the underlying semiconductor layer 23, which is locally short-circuited to the underlying epitaxial layer 22 by means of the diffused region 35 of $N^{++}$-type conductivity on the walls of the "mesa" groove.

Into the interior of the enhanced base region 24 there is diffused a region 26 of the $N^{++}$-type conductivity which constitutes the emitter region of the transistor. A metallic element 28 which is in ohmic contact with region 26 constitutes the emitter electrode 28.

The structure of Fig. 2 is completed by thermally growing at an elevated temperature a silicon dioxide layer 32 having a thickness between 0.2 and 2 $\mu$m. The layer 32 uniformly covers the surface 27 as well as the walls and the bottom of groove 36.

Provided that the purity of the silicon dioxide 32 is definitely given, the structure of the present invention shows excellent stability and reliability and, moreover, withstands increased collector breakdown voltages.

Since the collector region 2l, 22 extends to below the upper surface 27, the equipotential lines shown in the figure and produced by the electrical field when the collector-to-base junction is biased by high inverse voltages, are all concentrated within the space between the base electrode 29 and the diffused walls 33. Due to the distribution of the impurity concentration within said space, which is intended to vary the quantity of charges according to a distribution which makes said equipotential lines equally spaced, there is obtained an electrical field at the surface of the structure which is tangential on the surface 27 and has a value which lies below a predetermined value.

When comparing the transistor of Fig. l with that shown in Fig. 2 the substantial difference becomes apparent between the equipotential lines obtained when applying equal inverse voltages.

Moreover, it becomes evident that due to the modified electrical field the transistor of Fig. 2 may better withstand higher inverse voltages, when compared with the transistor shown in Fig. l.

Although there has been described a specific embodiment of the present invention hereinabove, it will be clear for those skilled in the art that several modifications and alterations may be done without departing from the scope of the present invention. For example, referring to Fig. 2, the distance 39 between the two regions 25 and 3l may be zero, i.e., said two regions may contact each other. This may be the case when the breakdown voltage of the transistor need not be very high, whereby, a substantial reduction of the dimensions of the chip can be achieved.

On the contrary, in case the breakdown voltage between collector and base of the transistor must be very high, the structure of Fig. 2 may be modified such that by adding further implanted regions the base regions 24, 25 and the collector region 3l are prolonged in accordance with the laws of predetermined concentration and variation.

It is to be noted that adjacent to region 24 of the enhanced base and the region 31 of the collector there may be present a certain number of additional implantation zones, at least one for each part (the latter case corresponds to the structure shown in Fig. 2). Said certain number of additional implantation zones (> =l) within the base region of the transistor depends mainly on the maximum voltage the device must withstand without breakdown: the higher the number of additional implantation zones, the higher the voltage which the junction can withstand.

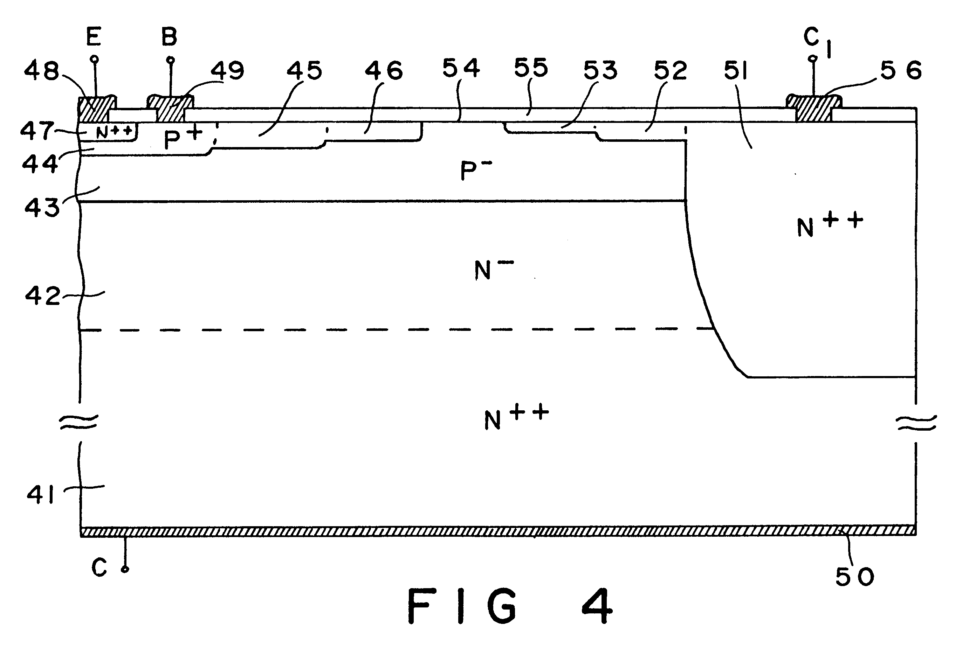

Fig. 4 shows an example of a transistor having two additional implantation zones 45 and 46 for the base and additional zones 52 and 53 for the collector.

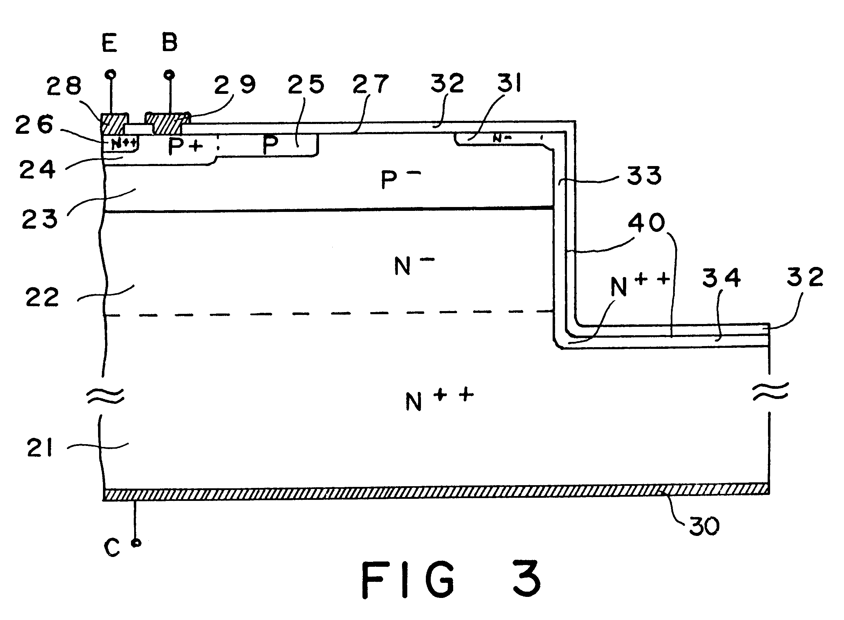

A modification of the transistor of Fig. 2 is shown in Fig. 3. The latter differs from the above-described form only in that the cavity and the auxiliary collector electrode C are not present, whereas a "mesa" structure 40 in the form of a step is provided.

A further modification of the transistor shown in Fig. 2 is depicted in Fig. 4. Fig. 4 shows a further embodiment of the invention. As shown in Fig. 4, substrate 4l, epitaxial layers 42 and 43, regions 44, 45, 46 and 47 and electrodes 48, 49 and 50 are equal to the corresponding elements of the structure of fig. 2.

In the modified embopdiment a region 5l is formed by way of a deep diffusion of a dopant of the $N^{++}$-type conductivity extending into substrate 4l such that the collector region of the substrate extends up to surface 54. Regions 52 and 53 of N-type conductivity prolong said region 5l of the collector beneath the silicon dioxide layer 55 in which a metallic element 56 forms an auxiliary collector electrode $C_1$.

It is evident that the present invention described for a NPN transistor is also applicable to the manufacture of PNP transistors. The modifications necessary for manufdacturing a PNP transistor are well known to those skilled in the art.

Moreover, it is evident that the layer which is epitaxially grown on the substrate and which, together with the substrate, constitutes the collector region of the transistors shown in Figures l to 4, may be omitted completely. Alternatively said epitaxial layer may be constituted by more than one epitaxial layer, wherein each layer has a conductivity which decreases in the direction toward the PN junction. This depends on the electrical field which may be more or less intense within the device.

Moreover, it is evident that the horizontal geometry of the devices of the present invention may assume any form, for example, interdigital structures may constitute the base and emitter regions of a multicellular transistor.

The present invention is not restricted to discrete devices, e.g. discrete diodes and transistors, but the invention is applicable to all semiconductor devices in which structures of the above described type are necessary.

**Claims**

1.  A semiconductor device, comprising:
    - a substrate (21, 22, 41, 42) of a monocrystalline semiconductor material of a first conductivity type (N),
    - a semiconductor layer (23, 43) of a second conductivity type (P), opposite to said first conductivity type, disposed on the substrate for forming a plane PN junction therewith,
    - an insulating layer (32, 55) which at least partially covers the semiconductor layer surface (27, 54) opposite to the PN junction,
    - first (30, 50) and second (29, 49) conductive means constituting ohmic contacts to the substrate (21, 22, 41, 42) and to the semiconductor layer (23, 43), respectively,
    - a first region (33, 34, 35, 51) limiting an active portion of the device and extending from said surface (27, 54) through the entire semiconductor layer (23, 43) and a part of the substrate (21, 22, 41, 42) thereby intersecting said plane PN junction, and
- a third region (24, 44) of the second conductivity type within said active portion, extending above and parallel to the substrate (21, 22, 41, 42) and having an impurity concentration which at all locations is higher than that of the semiconductor layer (23, 43),
  the ohmic contact of the second conductive means (29, 49) with the semiconductor layer (23, 43) being located on the third region (24, 44),
  characterized by:
- a second region (31, 52, 53) being of said first conductivity type and extending from the first region (33, 34, 35, 51), which is of said first conductivity type, into the active portion, the impurity concentration of the second region (31, 52, 53) being lower than that of the first region (33, 34, 35, 51), and
- a fourth region (25, 45, 46) of the second conductivity type surrounding the third region (24, 44) and having an impurity concentration which at all locations is higher than that of the semiconductor layer (23, 43) and lower than that of the third region (24, 44).

2. The semiconductor device according to claim 1, characterized in that said second region (31) and said fourth region (25) contact each other.

3. The semiconductor device according to claim 1 or 2, characterized in that said first region (51) is limited by a surface coplanar with said surface (54) of the semiconductor layer (43), and that said insulating layer (55) extends also across said coplanar surface.

4. The semiconductor device according to any of claims 1 to 3, characterized in that the first region (33, 34, 35) is limited by a groove (36), and that said insulating layer (32) extends also on the walls (33, 35) and the bottom (34) of said groove (36).

5. The semiconductor device according to any of the preceding claims, characterized in that third conductive means (38; 56) are provided which constitute an ohmic contact with said first region (33, 34, 35, 37; 51).

**Revendications**

1. Dispositif semiconducteur comprenant :
   - un substrat (21, 22, 41, 42) d'un matériau semiconducteur monocristallin d'un premier type de conductivité (N),
   - une couche semiconductrice (23, 43) du second type de conductivité (P) opposé au premier type de conductivité, disposée sur le substrat pour former une jonction PN plane avec celui-ci,
   - une couche isolante (32, 55) qui recouvre au moins partiellement la surface de la couche semiconductrice (27, 54) en face de la jonction PN,
   - des premiers (30, 50) et seconds (29, 49) moyens conducteurs constituant des contacts ohmiques vers le substrat (21, 22, 41, 42) et vers la couche semiconductrice (23, 43), respectivement,
   - une première région (33, 34, 35, 51) limitant une partie active du dispositif et s'étendant à partir de ladite surface (27, 54) à travers toute la couche semiconductrice (23, 43) et une partie du substrat (21, 22, 41, 42), coupant ainsi la jonction PN plane, et
   - une troisième région (24, 44) du second type de conductivité dans la partie active, s'étendant au-dessus du substrat (21, 22, 41, 42) et parallèlement à celui-ci, et ayant une concentration en impuretés qui, à tous les emplacements, est supérieure à celle de la couche semiconductrice (23, 43),
   le contact ohmique des seconds moyens conducteurs (29, 49) avec la couche semiconductrice (23, 43) étant disposé sur la troisième région (24, 44),
   caractérisé par :
   - une seconde région (31, 52, 53) du premier type de conductivité s'étendant à partir de la première région (33, 34, 35, 51), qui est du premier type de conductivité, dans la partie active, la concentration en impuretés de la seconde région (31, 52, 53) étant inférieure à celui de la première région (33, 34, 35, 51), et
   - une quatrième région (25, 45, 46) du second type de conductivité entourant la troisième région (24, 44) et ayant une concentration en impuretés qui, à tous les emplacements, est supérieure à celle de la couche semiconductrice (23, 43) et inférieure à celle de la troisième région (24, 44).

2. Dispositif semiconducteur selon la revendication 1, caractérisé en ce que la seconde région (31) et la quatrième région (25) sont en contact l'une avec l'autre.

3. Dispositif semiconducteur selon la revendication 1 ou 2, caractérisé en ce que la première région (51) est limitée par une surface coplanaire à la surface (54) de la couche semiconductrice (43) et en ce que la couche isolante (55) s'étend également à travers ladite surface coplanaire.

4. Dispositif semiconducteur selon l'une quelconque des revendications 1 à 3, caractérisé en ce que la première région (33, 34, 35) est limitée par une rainure (36) et en ce que la couche isolante (32) s'étend également sur les parois (33, 35) et le fond (34) de la rainure (36).

5. Dispositif semiconducteur selon l'une quelconque des revendications précédentes, caractérisé en ce que des troisièmes moyens conducteurs (38, 56) sont prévus et constituent un contact ohmique avec la première région (33, 34, 35, 37 ; 51).

**Patentansprüche**

1. Halbleitervorrichtung, umfassend:
   - ein Substrat (21, 22, 41, 42) aus einem einkristallinen Halbleitermaterial eines ersten Leitfähigkeitstyps (N),
   - eine Halbleiterschicht (23, 43) eines dem ersten Leitfähigkeitstyp entgegengesetzten, zweiten Leitfähigkeitstyps (P), die auf dem Substrat angeordnet ist und einen planaren PN-Übergang mit diesem bildet,
   - eine Isolierschicht (32, 55), die die dem PN-Übergang entgegengesetzte Oberfläche (27, 54) der Halbleiterschicht wenigstens teilweise überdeckt,
   - eine erste (30, 50) und eine zweite (29, 49) leitfähige Einrichtung, die mit dem Substrat (21, 22, 41, 42) bzw. mit der Halbleiterschicht (23, 43) ohmsche Kontakte bilden,
   - eine erste Zone (33, 34, 35, 51), die einen aktiven Bereich der Vorrichtung begrenzt und sich von der genannten Oberfläche (27, 54) durch die gesamte Halbleiterschicht (23, 43) und einen Teil des Substrats (21, 22, 41, 42) hindurcherstreckt und dadurch den planaren PN-Übergang schneidet, und
   - eine dritte Zone (24, 44) des zweiten Leifähigkeitstyps innerhalb des aktiven Bereichs, die sich über und parallel zu dem Substrat (21, 22, 41, 42) erstreckt und eine Verunreinigungskonzentration besitzt, die an allen Stellen höher ist als die der Halbleiterschicht (23, 43), wobei sich der ohmsche Kontakt der zweiten leitfähigen Einrichtung (29, 49) mit der Halbleiterschicht (23, 43) in der dritten Zone (24, 44) befindet, gekennzeichnet durch
   - eine zweite Zone (31, 52, 53) des ersten Leitfähigkeitstyps, die sich von der ersten Zone (33, 34, 35, 51) des ersten Leitfähigkeitstyps in den aktiven Bereich erstreckt, wobei die Verunreinigungskonzentration der zweiten Zone (31, 52, 53) niedriger ist als die der ersten Zone (33, 34, 35, 51),
   - und durch eine vierte Zone (25, 45, 46) des zweiten Leitfähigkeitstyps, die die dritte Zone (24, 44) umgibt und eine Verunreinigungskonzentration aufweist, die an allen Stellen höher als die der Halbleiterschicht (23, 43) und geringer als die der dritten Zone (24, 44) ist.

2. Halbleitervorrichtung nach Anspruch 1, dadurch gekennzeichnet, daß sich die zweite Zone (31) und die vierte Zone (25) miteinander in Kontakt befinden.

3. Halbleitervorrichtung nach Anspruch 1 oder 2, dadurch gekennzeichnet, daß die erste Zone (51) durch eine mit der Oberfläche (54) der Halbleiterschicht (43) koplanare Oberfläche begrenzt ist, und daß sich die Isolierschicht (55) auch über die koplanare Oberfläche erstreckt.

4. Halbleitervorrichtung nach einem der Ansprüche 1 bis 3, dadurch gekennzeichnet, daß die erste Zone (33, 34, 35) durch eine Nut (36) begrenzt ist, und daß sich die Isolierschicht (32) auch über die Wände (33, 35) und den Boden (34) der Nut (36) erstreckt.

5. Halbleitervorrichtung nach einem der vorausgehenden Ansprüche, dadurch gekennzeichnet, daß eine dritte leitfähige Einrichtung (38; 56) vorgesehen ist, die einen ohmschen Kontakt mit der ersten Zone (33, 34, 35, 37; 51) bildet.

FIG 1

EP 0 232 510 B1

FIG 2

FIG 3

EP 0 232 510 B1

F I G   4

EP 0 232 510 B1